# EUROPÄISCHE PATENTSCHRIFT

(11) **EP 1 018 119 B1**
(45) Veröffentlichungstag und Bekanntmachung des Hinweises auf die Patenterteilung: **23.01.2002**
(21) Anmeldenummer: 98958160.8
(22) Anmeldetag: 22.09.1998
(51) Int. Cl.: G11C 16/06

(54) **VERFAHREN ZUR VERWENDUNG BEIM EINSATZ VON EEPROMS ALS PROGRAMMSPEICHER**
METHOD TO BE APPLIED WHEN EEPROMs ARE USED AS PROGRAMME MEMORIES
PROCEDE APPLICABLE EN CAS D'UTILISATION DE MEMOIRES EEPROM COMME MEMOIRES PROGRAMME

(30) Priorität: 24.09.1997 DE 19742176
(43) Veröffentlichungstag der Anmeldung: 12.07.2000
(73) Patentinhaber: Infineon Technologies AG, 81669 München (DE)
(72) Erfinder: KERBER, Martin, D-81827 München (DE); SCHMECKEBIER, Olaf, D-81373 München (DE); KESSLER, Elke, D-85614 Kirchseeon (DE); FALTERMEIER, Josef, D-93179 Brennberg (DE)
(74) Vertreter: Epping Hermann & Fischer
(86) Internationale Anmeldenummer: DE9802831
(87) Internationale Veröffentlichungsnummer: WO9916079

(56) Entgegenhaltungen:
- EP-A- 0 791 933
- WO-A-93/23806
- WO-A-97/05623

## Beschreibung

Die Erfindung betrifft ein Verfahren zur Verwendung beim Einsatz von elektrisch umprogrammierbaren, nichtflüchtigen Halbleiterspeichern als Programmspeicher in Mikrocontrollern oder Computern, bei dem ein Verfahrensanweisung in einer Verfahrensschleife ständig wiederholt wird.

Elektrisch umprogrammierbare, nichtflüchtige Halbleiterspeicher stehen durch die Entwicklung von EEPROMs zu relativ geringen Kosten zur Verfügung und werden vermehrt als Speichermedium für Programmspeicher in Mikrocontrollern und Computern an Stelle der bisher üblichen maskenprogrammierten ROM-Speicher eingesetzt. Dabei werden insbesondere Floating-Gate Speicherzellen (FLOTOX) und Flash-EEPROM Zellen eingesetzt.

Ein Problem kann sich bei solchen nichtflüchtigen Halbleiterspeichern mit einer dielektrisch isolierten Floating-Gate Schicht jedoch daraus ergeben, daß diese die Informationen nicht beliebig lange halten. Insbesondere beim Lesen treten Spannungen zwischen dem Floating-Gate und dem Drainknoten auf, die einen Tunnelstrom fließen lassen. Dieser Mechanismus wird als Read Disturb bezeichnet. Dieser Effekt tritt insbesondere dann auf, wenn eine gelöschte Speicherzelle (Elektronen am Floating-Gate), bei der das Potential des Floating-Gate negativer als die Einsatzspannung des Speichertransistors ist, wiederholt ausgelesen wird. Dieser Transistor sperrt, so daß die jeweils maximale Spannung am Tunneloxid anliegt.

Beim Einsatz von EEPROM Zellen als Programmspeicher ist es daher vorgekommen, daß insbesondere bei Zellen, die mehrfach umprogrammiert worden sind, ein derartiger Leckstrom auftritt, der zum Verlust der Informationen und damit zu einem Programmfehler führen kann. Zur Lösung dieses Problems sind verschiedene Ansätze bekannt. So wird versucht, den Leckstrom durch ein dickeres Tunneloxid oder kleinere Drainspannungen beim Auslesen der Information zu begrenzen. Bei einem anderen Ansatz hat man versucht, die Anzahl der Umprogrammierzyklen zu begrenzen, um die Zelle weniger zu schädigen.

In EP-A-0 791 933 wird das Problem so gelöst, daß die Speicherzellen aufgefrischt werden. In WO93/23806 wird die Adresse zum Schreiben immer wieder geändert werden, so daß das Schreiben über den ganzen Speicher verteilt wird.

Der Erfindung liegt die Aufgabe zugrunde, den Einsatz von elektrisch umprogrammierbaren, nichtflüchtigen Halbleiterspeichern als Programmspeicher in Mikrocontrollern oder Computern zu ermöglichen, so daß die Halbleiterspeicher unverändert verwendet werden können und die Vorteile der umprogrammierbaren, nichtflüchtigen Halbleiterspeicher besonders gut ausgenutzt werden können.

Die Lösung dieser Aufgabe erfolgt mit einem Verfahren der eingangs genannten Art, bei dem der sich ständig wiederholende Verfahrensschritt durch mindestens einen wesensgleichen Verfahrensschritt innerhalb derselben Verfahrensschleife ergänzt wird, wobei die Verfahrensschritte innerhalb derselben Verfahrensschleife auf verschiedene Speicherzellen zugreifen.

Nach einem Grundgedanken der Erfindung ist erkannt worden, daß der Datenverlust in mehrfach umprogrammierten Speichern insbesondere infolge andauernden oder ständigen Auslesens derselben Speicherzelle erfolgt. Andauerndes Lesen ist dann gegeben, wenn eine minimale Schleife andauernd durchlaufen wird, um etwa 1 bit einer Speicherzelle abzufragen. Durch das erfindungsgemäße Verfahren wird eine Entschärfung der kritischen Programmstellen erreicht, wobei zusätzliche Abfragen in die Schleife eingebaut werden, die bewirken, daß die Schleife auf mehrere Speicherstellen verteilt wird.

Durch das erfindungsgemäße Verfahren können mehr Umprogrammierzyklen durchgeführt werden und dünnere Tunneloxide eingesetzt werden, die ihrerseits kleinere Programmierspannungen und entsprechende Flächen- und Kostenvorteile bewirken. Das erfindungsgemäße Verfahren ermöglicht weiterhin höhere Drainspannungen und damit auch höhere Drainströme. Ebenso sind höhere Betriebstemperaturen, die einen höheren Strom zur Folge haben, zulässig.

Die wesensgleichen Verfahrensschritte sind bevorzugt komplementär formulierte Bedingungen. Das bedeutet, daß beispielsweise eine Ja/Nein-Entscheidung genau umgekehrt zur Schleifenwiederholungsbedingung formuliert wird, so daß im Falle einer Schleifenwiederholung im Falle des Eintritts des Ereignisses die komplementär formulierte Bedingung gerade so formuliert werden muß, daß bei Eintritt des Ereignisses die Schleife weiterläuft und bei Nichteintritt des Ereignisses ein Sprung nach außerhalb der Schleife erfolgt. Insbesondere werden zwei oder mehr wesensgleiche Verfahrensschritte ergänzt, da durch jeden zusätzlichen Verfahrensschritt die Belastung der einzelnen Speicherzellen linear verringert wird. Bei drei zusätzlichen Verfahrensschritten ist daher nur noch eine Speicherbelastung von einem Drittel und bei zehn zusätzlichen Verfahrensschritten nur noch eine Speicherbelastung von 10 % gegeben.

Bevorzugt greifen die Verfahrensschritte innerhalb einer Verfahrensschleife jeweils auf verschiedene, vorher festgelegte Speicherzellen zu. Insbesondere greifen die Verfahrensschritte innerhalb einer Verfahrensschleife jeweils auf die nächstfolgende Speicherzelle zu. Durch eine solche klare Zuordnung der Verfahrensschritte auf bestimmte Speicherzellen wird sichergestellt, daß eine definierte und kontrollierbare gleichmäßige Belastung der Speicherzellen erfolgt.

In einer anderen Weiterbildung der Erfindung erfolgt nach einer vorgegebenen Betriebsdauer ein Zugriff auf andere Speicherzellen. Dabei kann entweder die Betriebsdauer oder eine bestimmte Anzahl von Schleifenabbrüchen zum maßgebenden Faktor für den Zugriff auf andere, bisher noch nicht belastete Speicherzellen gemacht werden.

Nachfolgend wird die Erfindung anhand eines in der Zeichnung dargestellten Ausführungsbeispiels weiter erläutert. Im einzelnen zeigen die schematischen Darstellungen in:
- Fig. 1: einen schematischen Querschnitt durch eine EEPROM Speicherzelle;
- Fig. 2: Strom-Spannungskennlinien einer EEPROM Speicherzelle nach unterschiedlicher Degradation des Tunneloxides durch zunehmende Anzahl von Umprogrammierzyklen;
- Fig. 3: den zeitlichen Verlauf der gespeicherten Ladung eines Floating-Gates bei unterschiedlichen Ausmaßen der Degradation;
- Fig. 4: einen typischen Verfahrensablauf einer minimalen Schleife; und
- Fig. 5: einen erfindungsgemäßen Verfahrensablauf.

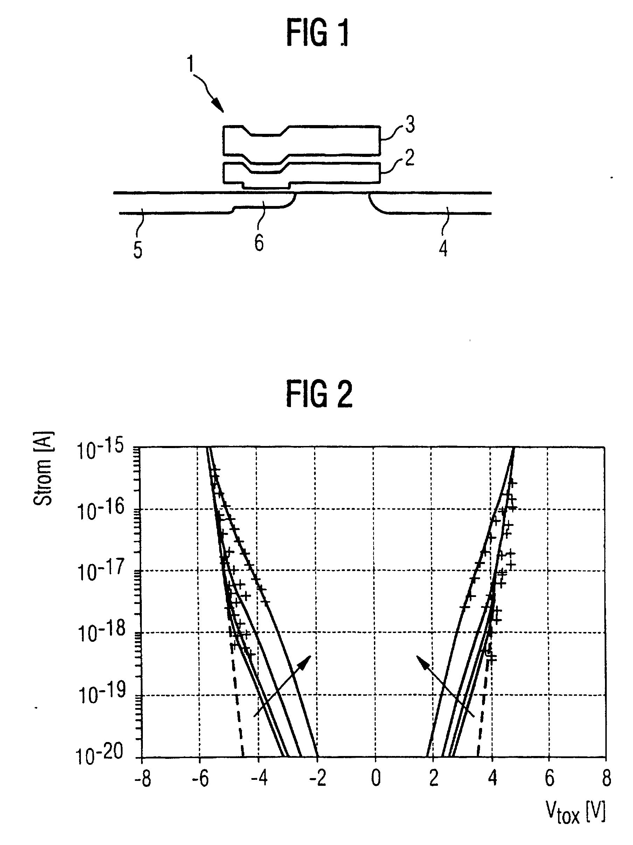

In Fig. 1 ist eine mit 1 bezeichnete EEPROM Speicherzelle im Querschnitt dargestellt. In dem Floating-Gate 2 wird die Ladung in einer rundum isolierten Poylsiliziumstruktur gespeichert. Die Umladung erfolgt durch Elektronen, die die dünne Oxidschicht zwischen Halbleiter und Floating-Gate 2 durchtunneln. Neben dem Floating-Gate 2 sind das Control-Gate 3, Sourcebereich 4, Drainbereich 5 und der Tunnelimplantationsbereich 6 dargestellt. Das dielektrisch isolierte Floating-Gate 2 hält die gespeicherte Information nicht beliebig lange. Insbesondere beim Lesen treten Spannungen zwischen dem Floating-Gate und dem Drainknoten auf, durch die ein Tunnelstrom fließt und das Floating-Gate entladen werden kann. Dieser Mechanismus wird als Read Disturb bezeichnet. Bei frischen und wenig belasteten EEPROM Zellen ist der Strom hinreichend klein, so daß innerhalb der Lebensdauer kein Verlust der logischen Information zu befürchten ist. Durch mehrfaches Umprogrammieren tritt aber ein Leckstrom (Stress Induced Leakage Current, abgekürzt SILC) auf, der bei dauerhaftem Lesen zum Verlust der Information und damit zu einem Programmfehler führt.

In Fig. 2 ist der Strom im Bereich des Tunnelfensters einer EEPROM Speicherzelle gegen die Spannung aufgetragen. Der Leckstrom wird mit zunehmender Anzahl von Umprogrammierzyklen größer. Dies ist in den verschiedenen Meßreihen in Dekaden-Schritten von 10³ bis 10⁶ gemessen und in Fig. 2 dargestellt worden. Die Pfeile deuten dabei die Richtung zunehmender Anzahl von Programmierzyklen an. Je öfter die Zelle umprogrammiert wird, desto früher tritt der Informationsverlust auf. Dieser Effekt findet verstärkt in Speicherzellen mit dünnen Tunneloxiden statt.

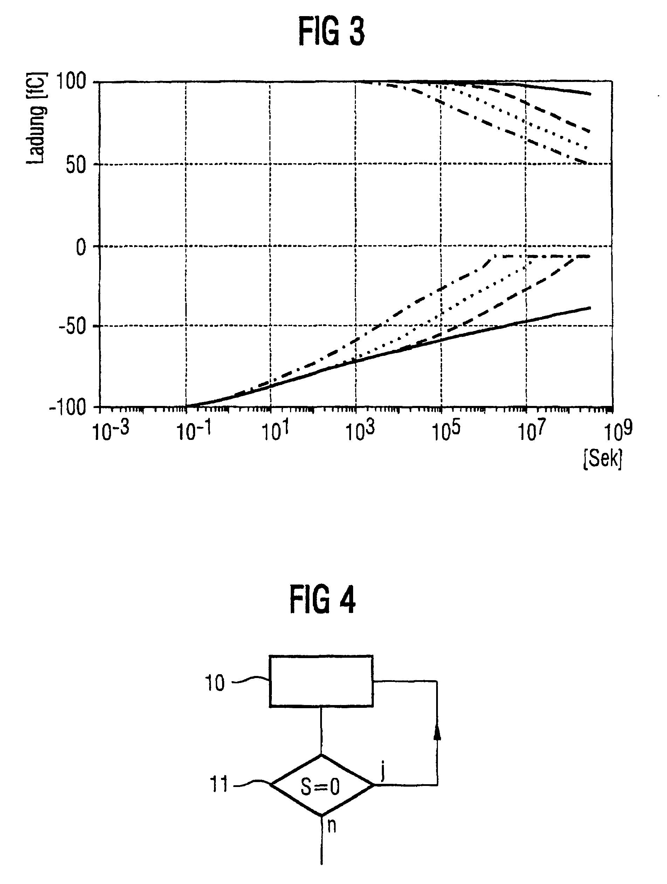

In Fig. 3 ist die Abnahme der im Floating-Gate gespeicherten Ladung gegen die Zeit aufgetragen. Die durchgezogene Linie zeigt das Verhalten einer frischen Speicherzelle an, bei der die gespeicherte Ladung zwar abnimmt, aber nach 10⁸ Sekunden (ungefähr 3 Jahre) die Information noch sicher erkannt wird. Die gestrichelte Linie, die punktierte Linie und die strichpunktierte Linie ergeben das Verhalten einer durch wiederholtes Umprogrammieren (ca. 10³-mal, 10⁵-mal und 10⁷-mal) geschädigten Zelle wieder. Bei diesen durch wiederholtes Umprogrammieren geschädigten Zellen wird die Information wesentlich früher verändert. Diese Darstellung gilt für Zellen, die durch dauerhafte Spannung am Drainknoten belastet sind, was einem typischen Lesebetrieb entspricht.

Ein solcher Fall, bei dem innerhalb der Lebensdauer andauernd gelesen wird, tritt in typischen Programmen jedoch nur an wenigen Stellen auf. Dies sind insbesondere Programmschleifen, in denen sich der Controller im Wartezustand befindet, wobei externe Ereignisse abgefragt werden oder Endlosschleifen durchlaufen werden, die durch Interrupt-Anforderungen unterbrochen werden. Diese Programmteile sind maßgeblich für die Lebensdauer des gesamten Programmspeichers.

In Fig. 4 ist beispielhaft ein Verfahrensablauf dargestellt, bei dem eine Signalabfrage 10 durchgeführt wird und anschließend eine Entscheidung bei 11 getroffen wird und abhängig vom Ergebnis das Signal erneut abgefragt wird. Wenn eine solche minimale Schleife andauernd durchlaufen wird, um etwa 1 bit einer Portleitung abzufragen, spricht man von andauerndem Lesen. In einem optimierten Programm wird dies durch zwei Befehle implementiert, die im ungünstigen Fall ständig zwei Speicherzellen abwechslungsweise auslesen.

Ein solches Verfahren kann in jeder beliebigen Computersprache durchgeführt werden. Beispielsweise könnte dies in Assembler lauten:

| | |
|---|---|
| | - |
| Loop | BTST Signal |
| | JMP cc_EQ, Loop |
| Cont | - |
| | - |

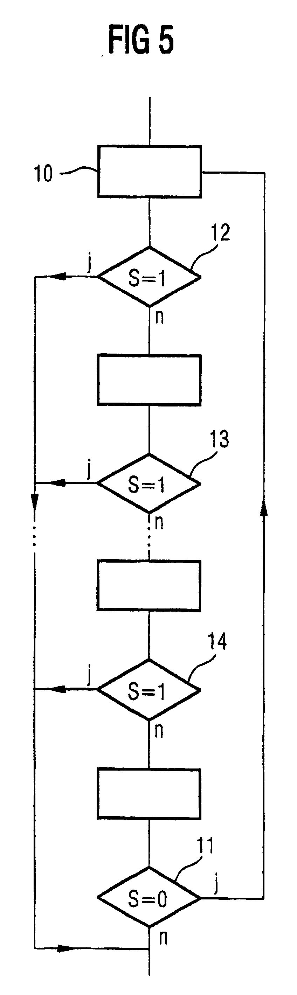

Erfindungsgemäß werden bei dem in Fig. 5 dargestellten Verfahren in die Schleife zusätzliche Abfragen eingebaut, durch die bei einem komplementären Ergebnis die Schleife verlassen wird. Neben der Signalabfrage 10 und der Schleifenbedingung 11 sind zusätzliche wesensgleiche Verfahrensschritte 12, 13 und 14 in die Schleife eingebaut worden, durch die die Schleife auf mehrere Speicherstellen verteilt wird. Da dadurch die Belastung der einzelnen Zellen linear mit der Anzahl der Abfragen reduziert wird, wird dadurch die Datensicherheit erhöht. Die Anzahl der zusätzlichen Abfragen ist dabei beliebig. Ein in Assembler formuliertes, erfindungsgemäßes Verfahren könnte beispielsweise lauten:

| | |
|---|---|
| | - |
| Loop | BTST Signal |
| | JMP cc_NE,Cont |
| | BTST Signal |
| | JMP cc_NE, Cont |
| | BTST Signal |
| | JMP cc_EQ Loop |
| Cont | - |
| | - |

Bei der Abarbeitung dieses Programms wird bei dem Befehl BTST Signal (Bittest Signal) ein bestimmtes Bit ausgelesen und verglichen. In der darauf folgenden Zeile erfolgt ein Sprungbefehl (Jump) zu der Marke "Cont", falls das Ergebnis des Vergleichs "ungleich" ist (NE bedeutet not equal). In den beiden darauffolgenden Zeilen wird dieser Ablauf wiederholt. Im dritten Bittest erfolgt die Schleifenabbruchbedingung durch den Sprung zu der Marke "Loop", falls die Bedingung ein "gleich" ergibt. Zu dieser Schleifenabbruchbedingung sind die beiden anderen Bedingungen wesensgleich, da auch bei Ihnen im Fall "gleich" die Schleife fortgesetzt wird und im Fall "nichtgleich" durch den Sprungbefehl zu der Marke "Cont" die Schleife verlassen wird. Ebenso wird bei der Schleifenwiederholungsbedingung im Falle der Ungleichheit der Sprung nicht durchgeführt und die Schleife fortgesetzt, so daß sich auch dort eine Fortführung des Programms bei "Cont" ergibt. Wie bei der oben dargestellten minimalen Schleife wird immer das Signal getestet und anschließend entschieden, ob die Schleife fortgesetzt oder verlassen wird. Im Gegensatz zu der minimalen Schleife wird hier jedoch nicht ständig dieselbe Programmzeile wiederholt, sondern statt dessen innerhalb der Schleife verschiedene Programmzeilen abgearbeitet, wodurch jeweils andere Speicherplätze benutzt werden.

Im Vergleich zu dem obigen, konkreten Programmbeispiel wird in Fig. 5 ein Flußdiagramm dargestellt. In der Signalabfrage 10 wird jeweils ein Signal abgefragt und mit den folgenden Abfragen überprüft. Bei S=0 erfolgt also in den zur Schleifenabbruchbedingung 11 komplementär formulierten Abfragen 12, 13 und 14 jeweils die Antwort NEIN, so daß die Schleife weiter durchlaufen wird. Im Verfahrensschritt 11 erfolgt bei S=0 das Ergebnis JA, so daß die Schleife wiederholt wird. Das bedeutet, daß bei S=0 die Schleife ständig wiederholt wird, wobei jedoch durch die komplementär formulierten Abfragen 12, 13 und 14 und beliebig viele weitere gleiche Abfragen der Zugriff auf verschiedene Speicherstellen verteilt wird. Bei S=1 erfolgt im Verfahrensschritt 12, 13 oder 14 ein Sprung aus der Schleife heraus.

## Patentansprüche

1. Verfahren zur Verwendung beim Einsatz von elektrisch umprogrammierbaren, nichtflüchtigen Halbleiterspeichern als Programmspeicher in Mikrocontrollern oder Computern, bei dem ein Verfahrensschritt in einer Verfahrensschleife ständig wiederholt wird,
**dadurch gekennzeichnet,**
**daß** der sich ständig wiederholende Verfahrensschritt durch mindestens einen wesensgleichen Verfahrensschritt innerhalb derselben Verfahrensschleife ergänzt wird, wobei die Verfahrensschritte innerhalb derselben Verfahrensschleife auf verschiedene Speicherzellen zugreifen.

2. Verfahren nach Anspruch 1,
**dadurch gekennzeichnet,**
**daß** als wesensgleiche Verfahrensschritte komplementär formulierte Bedingungen verwendet werden.

3. Verfahren nach einem der Ansprüche 1 oder 2,
**dadurch gekennzeichnet,**
**daß** zwei oder mehr wesensgleiche Verfahrensschritte ergänzt werden.

4. Verfahren nach einem der vorhergehenden Ansprüche,
**dadurch gekennzeichnet,**
**daß** die Verfahrensschritte innerhalb einer Verfahrensschleife jeweils auf verschiedene, vorher festgelegte Speicherzellen zugreifen.

5. Verfahren nach einem der vorhergehenden Ansprüche,
**dadurch gekennzeichnet,**
**daß** die Verfahrensschritte innerhalb einer Verfahrensschleife jeweils auf die nächstfolgende Speicherzelle zugreifen.

6. Verfahren nach einem der vorhergehenden Ansprüche,
**dadurch gekennzeichnet,**
**daß** nach einer vorgegebenen Betriebsdauer auf andere Speicherzellen zugegriffen wird.

## Claims

1. Method for use when electrically reprogrammable, non-volatile semiconductor memories are used as program memories in microcontrollers or computers, in which a method step is continually repeated in a method loop,
**characterized**
**in that** the continually repeating method step is supplemented by at least one essentially identical method step within the same method loop, the method steps within the same method loop accessing different memory cells.

2. Method according to Claim 1,
**characterized**
**in that** complementarily formulated conditions are used as essentially identical method steps.

3. Method according to either of Claims 1 and 2,
**characterized**
**in that** two or more essentially identical method steps are supplemented.

4. Method according to one of the preceding claims,
**characterized**
**in that** the method steps within a method loop each access different memory cells defined beforehand.

5. Method according to one of the preceding claims,
**characterized**
**in that** the method steps within a method loop each access the next memory cell.

6. Method according to one of the preceding claims,
**characterized**
**in that**, after a predetermined operating duration, other memory cells are accessed.

## Revendications

1. Procédé qui est applicable lors de l'utilisation de mémoires à semi-conducteurs électriquement reprogrammables et non volatiles comme mémoires de programmes dans des microcontrôleurs ou dans des ordinateurs et dans lequel une instruction de procédure est constamment répétée dans une boucle de procédure,
**caractérisé par le fait qu'**on complète l'étape de procédure qui se répète constamment par au moins une étape de procédure équivalente à l'intérieur de la même boucle de procédure, les étapes de procédure à l'intérieur de la même boucle de procédure accédant à des cellules de mémoire différentes.

2. Procédé selon la revendication 1,
**caractérisé par le fait qu'**on utilise comme étapes de procédure équivalentes des conditions formulées de manière complémentaire.

3. Procédé selon l'une des revendications 1 ou 2,
**caractérisé par le fait qu'**on complète par deux étapes ou plus de procédure équivalentes.

4. Procédé selon l'une des revendications précédentes,
**caractérisé par le fait que** les étapes de procédure à l'intérieur d'une boucle de procédure accèdent à chaque fois à des cellules de mémoire différentes fixées à l'avance.

5. Procédé selon l'une des revendications précédentes,
**caractérisé par le fait que** les étapes de procédure à l'intérieur d'une boucle de procédure accèdent à chaque fois à la cellule de mémoire immédiatement suivante.

6. Procédé selon l'une des revendications précédentes,
**caractérisé par le fait qu'**on accède à d'autres cellules de mémoire après une durée de fonctionnement prédéterminée.
